(19) **Europäisches Patentamt European Patent Office Office européen des brevets**

(11) **EP 2 441 099 B1**

(12) **FASCICULE DE BREVET EUROPEEN**

(45) Date de publication et mention de la délivrance du brevet:
**01.05.2013   Bulletin 2013/18**

(21) Numéro de dépôt: **10731766.1**

(22) Date de dépôt: **11.05.2010**

(51) Int Cl.:
*H01L 35/32* $^{(2006.01)}$     *H01L 35/34* $^{(2006.01)}$

(86) Numéro de dépôt international:
**PCT/FR2010/050904**

(87) Numéro de publication internationale:
**WO 2010/142880 (16.12.2010 Gazette 2010/50)**

(54) **MICRO-STRUCTURE POUR GÉNÉRATEUR THERMOÉLECTRIQUE À EFFET SEEBECK ET PROCÉDÉ DE FABRICATION D'UNE TELLE MICRO-STRUCTURE**

MIKROSTRUKTUR FÜR EINEN THERMOELEKTRISCHEN GENERATOR MIT SEEBECK-EFFEKT UND VERFAHREN ZUR HERSTELLUNG EINER SOLCHEN MIKROSTRUKTUR

MICROSTRUCTURE FOR A SEEBECK EFFECT THERMOELECTRIC GENERATOR, AND METHOD FOR MAKING SUCH A MICROSTRUCTURE

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **12.06.2009   FR 0953930**

(43) Date de publication de la demande:
**18.04.2012   Bulletin 2012/16**

(73) Titulaire: **Commissariat à l'Énergie Atomique et aux Énergies Alternatives 75015 Paris (FR)**

(72) Inventeurs:
• **MINGO BISQUERT, Natalio**
  **F-38360 Sassenage (FR)**
• **CAROFF, Tristan**
  **F-29200 Brest (FR)**
• **PLISSONNIER, Marc**
  **F-38320 Eybens (FR)**
• **REMONDIERE, Vincent**
  **F-38000 Grenoble (FR)**
• **WANG, Shidong**
  **F-38000 Grenoble (FR)**

(74) Mandataire: **Vuillermoz, Bruno et al Cabinet Laurent & Charras "Le Contemporain" 50, Chemin de la Bruyère 69574 Dardilly Cédex (FR)**

(56) Documents cités:
WO-A1-00/30185          WO-A1-80/01438
JP-A- 2004 104 041      JP-A- 2004 179 480
JP-A- 2008 205 129      US-A1- 2005 178 424
US-A1- 2008 173 537     US-A1- 2009 025 774

EP 2 441 099 B1

**Description**

**DOMAINE DE L'INVENTION**

L'invention a trait au domaine des micro-générateurs thermoélectriques à effet Seebeck, c'est-à-dire des structures convertissant une énergie thermique en une énergie électrique, et dont les éléments fonctionnels sont inférieurs au millimètre.

**ETAT DE LA TECHNIQUE**

Les générateurs thermoélectriques à effet Seebeck ont pour fonction de transformer un gradient de température auquel ils sont soumis en un courant électrique. Une telle propriété est par exemple utilisée pour la génération de courant proprement dite, mais également pour réaliser un refroidissement ou encore une mesure de température ou de flux thermique. Les générateurs thermoélectriques sont ainsi couramment utilisés dans les systèmes micro-électro-mécaniques, mieux connus sous l'acronyme anglo-saxon MEMS.

Pour produire du courant électrique à partir d'un gradient de température, on crée un ensemble de jonctions de matériaux présentant des coefficients Seebeck différents connectés électriquement en série et thermiquement en parallèle, tels que par exemple des jonctions P-N connectées en série.

Quel que soit le type de structures réalisées pour ces connexions, qu'elles soient planes, comme dans le document US 6 872 879 ou le document US 2005/0178424 ou en colonne, comme dans le document « Thermoelectric microdevice fabricated by a MEMS-like electrochemical process » de G. Jeffrey Snyder et al, Nature materiels, vol.2, août 2003, www.nature.com/naturematerial, la nature microscopique des différents éléments (éléments conducteurs ou semi-conducteurs formant les jonctions ou des éléments de connexion par exemple de dimension inférieure au millimètre) impose usuellement des processus d'alignement très précis afin de réaliser lesdites jonctions de manière à obtenir une longue série de jonctions, gage d'efficacité thermoélectrique. De fait, la fabrication d'une micro-structure thermoélectrique nécessite la mise en oeuvre de nombreuses étapes par du matériel de précision. De fait les micro-structures thermoélectriques de l'état de la technique sont généralement onéreuses et longues à fabriquer.

**EXPOSE DE L'INVENTION**

Le but de la présente invention est de proposer un procédé de fabrication simple d'une micro-structure thermoélectrique qui ne nécessite pas la mise en oeuvre d'alignement très précis, tout en garantissant en outre une robustesse accrue de ladite structure vis-à-vis d'une rupture de jonction.

A cet effet, l'invention a pour objet un procédé de fabrication d'une micro-structure thermoélectrique à effet Seebeck, comportant les étapes suivantes :

■ formation d'un support isolant muni d'une première et d'une seconde zone de connexion;
■ formation sur le support d'un premier ensemble d'éléments conducteurs ou semi-conducteurs s'étendant parallèlement entre eux, et selon une première direction, de la première zone de connexion à la seconde zone de connexion, lesdits éléments présentant un premier coefficient Seebeck ;
■ formation sur le support d'un second ensemble d'éléments conducteurs ou semi-conducteurs, isolés électriquement des éléments du premier ensemble, s'étendant parallèlement entre eux, et selon une seconde direction, différente de la première direction, de la première zone de connexion à la seconde zone de connexion, les éléments du second ensemble présentant un second coefficient Seebeck différent du premier coefficient Seebeck ; et
■ réalisation dans les première et seconde zones de connexion du support d'éléments de connexion électrique, dont les dimensions sont sélectionnées de sorte que chacun desdits éléments de connexion est apte à connecter électriquement au moins un élément du premier ensemble à au moins un élément du second ensemble, dans lequel
■ deux éléments conducteurs ou semiconducteurs d'un même ensemble sont séparés, selon une direction prédéterminée, d'une distance moyenne prédéterminée dans les zones de connexion; et
■ la distance selon la direction prédéterminée entre les bords de deux éléments de connexion est inférieure au minimum des distances moyennes séparant les éléments d'un même ensemble.

Selon l'invention :

■ la dimension des éléments de connexion selon la direction prédéterminée est en moyenne supérieure à deux fois le maximum des distances moyennes séparant les éléments d'un même ensemble.

En d'autres termes, lors d'une première phase de fabrication de la micro-structure de l'invention, on forme les éléments qui serviront ultérieurement aux jonctions sans nécessairement se soucier de leur alignement au sein du même ensemble et sans se soucier de l'orientation relative précise du premier ensemble avec le second ensemble. Dans une seconde phase, ces éléments sont alors interconnectés pour former des jonctions à l'aide de connecteurs dont les dimensions sont en moyenne supérieure à deux fois l'espacement des éléments dans les zones de connexion. En procédant ainsi, on s'assure donc de former une pluralité de jonctions électriquement en série. En outre, de par les dimensions importantes des connecteurs, on réalise également plusieurs séries de jonctions en parallèle, de sorte que si une jonction venait à se rompre, il existe toujours un chemin parallèle pour le courant.

Alors que dans l'état de la technique, on cherche à obtenir une seule et unique série électrique de jonctions, nécessitant de fait un alignement précis des éléments, l'invention tire partie du fait que connecter ensemble plus de deux éléments adjacents n'est pas du tout désavantageux, et induit au contraire plus de robustesse. Ainsi, dans l'invention, il sera avantageusement recherché une densité de connexions électriques maximale, notamment pour multiplier les chemins électriques parallèles et donc, in fine, augmenter la robustesse de la structure, mais également pour s'affranchir au maximum d'un besoin de positionnement précis de ces connexions vis-à-vis des éléments constitutifs des jonctions. N'étant ainsi pas tenu à une recherche d'une connexion d'uniquement deux éléments, le procédé n'a donc pas besoin d'une précision élevée, ce qui simplifie la fabrication de la micro-structure.

Selon l'invention, les premier et second ensembles peuvent être formés respectivement sur des faces opposées du support isolant, la formation des éléments de connexion comprenant la réalisation de connexions électriques traversant le support entre les deux faces, notamment la formation d'au moins un trou traversant le support suivi de la formation de contacts conducteurs au sein de ce trou.

Selon une autre configuration de l'invention, les éléments conducteurs ou semi-conducteurs sont des bandes, des fils, des nanofils, et/ou des fibres monocristallines.

En variante, ils peuvent être constitués d'un film mince présentant une conductivité électrique anisotrope.

L'invention a également pour objet une micro-structure pour générateur thermoélectrique à effet Seebeck comportant :

■ un support isolant muni d'une première zone de connexion et d'une seconde zone de connexion ;
■ sur le support, un premier ensemble d'éléments conducteurs ou semi-conducteurs s'étendant parallèlement entre eux, et selon une première direction, entre la première zone de connexion et la seconde zone de connexion, lesdits éléments présentant un premier coefficient Seebeck ;
■ sur le support, un second ensemble d'éléments conducteurs ou semi-conducteurs isolés électriquement des éléments du premier ensemble, s'étendant parallèlement entre eux, et selon une seconde direction différente de la première direction, de la première zone de connexion à la seconde zone de connexion, les éléments du second ensemble présentant un second coefficient Seebeck différent du premier coefficient Seebeck ; et
■ dans les première et seconde zones de connexion, des éléments de connexion électrique connectant électriquement au moins un élément du premier ensemble à au moins un élément du second ensemble, dans laquelle
■ deux éléments conducteurs ou semiconducteurs d'un même ensemble sont séparés, selon une direction prédéterminée, d'une distance moyenne prédéterminée dans les zones de connexion ; et
■ la distance selon la direction prédéterminée entre les bords de deux éléments de connexion est inférieure au minimum des distances moyennes séparant les éléments d'un même ensemble.

Selon l'invention;

■ la dimension des éléments de connexion selon la direction prédéterminée est en moyenne supérieure à deux fois le des distances moyennes séparant les éléments d'un même ensemble;

Une telle structure, fabriquée selon le procédé précité, est robuste et de fabrication simple.

## BREVE DESCRIPTION DES FIGURES

L'invention sera mieux comprise à la lecture de la description qui va suivre, donnée uniquement à titre d'exemple, et réalisée en relation avec les dessins annexés, dans lesquels :

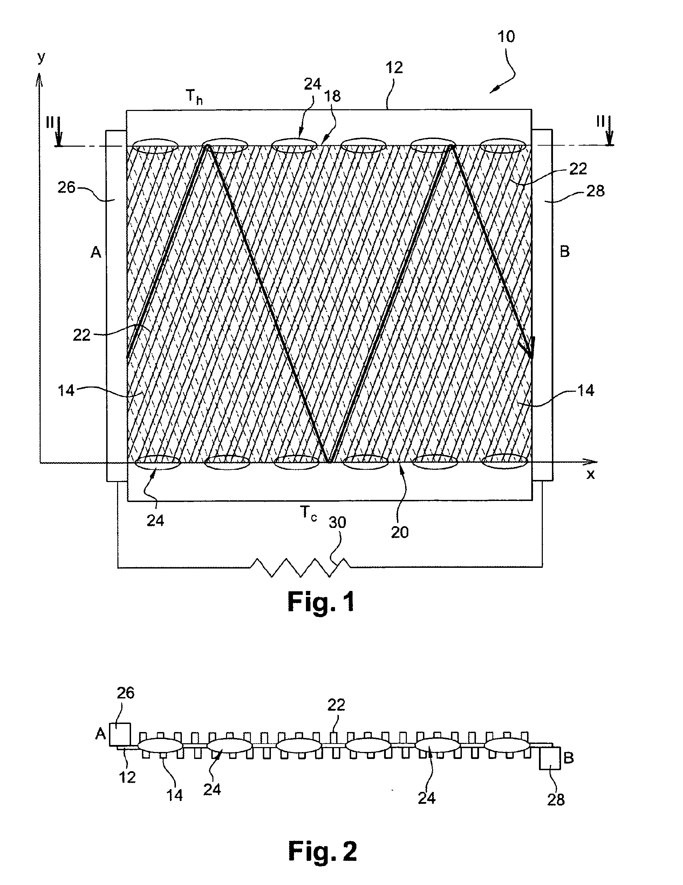

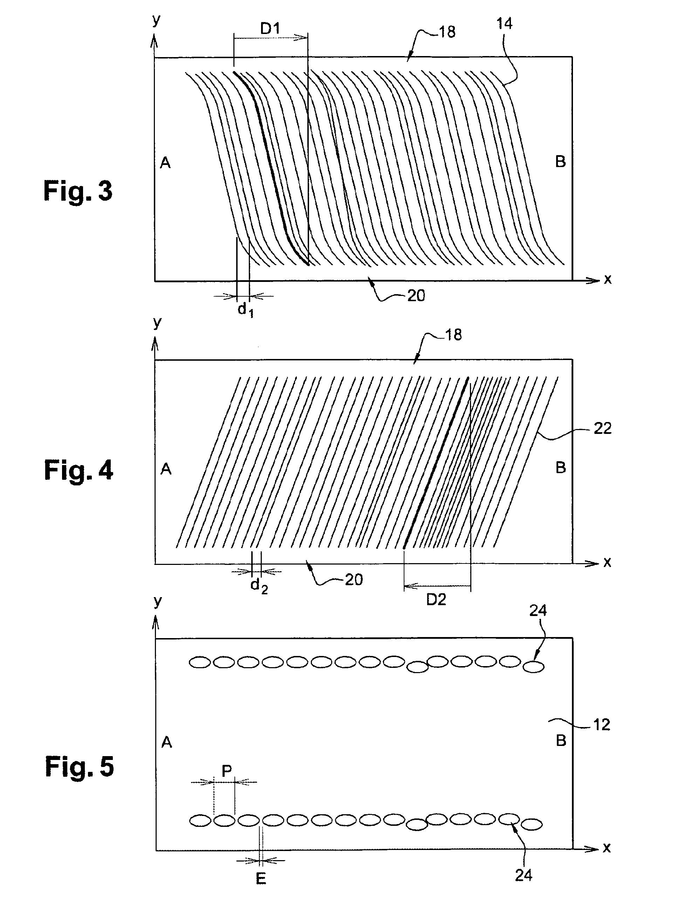

■ la figure 1 est une vue schématique de face d'une micro-structure thermoélectrique selon l'invention ;
■ la figure 2 est une vue schématique en section selon l'axe II-II de la micro-structure de la figure 1 ;
■ les figures 3 et 4 sont des vues schématiques illustrant des tracés des éléments conducteurs ou semi-conducteurs de la micro-structure selon l'invention ;
■ la figure 5 est une vue schématique de face d'un support isolant muni d'orifices de contact destiné être combiné avec les tracés des figures 3 et 4 ; et

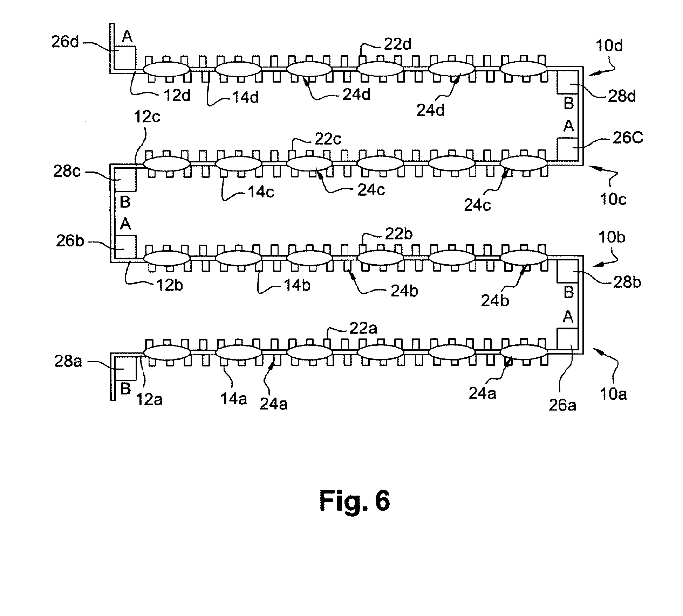

■ la figure 6 est une vue schématique d'un empilement de micro-structures selon l'invention.

## DESCRIPTION DETAILLEE DE L'INVENTION

Dans ce qui suit les expressions « haut », « bas », « droite » et « gauche » sont définies par rapport à la figure 1.

Sur les figures 1 et 2, un premier mode de réalisation d'une micro-structure thermoélectrique à effet Seebeck 10, par exemple réalisée en technologie couche mince, comme utilisée en microélectronique, selon l'invention comprend :

■ un support mince de matériau isolant **12,** par exemple un substrat ou un film mince ;

■ un ensemble de bandes **14** en un matériau conducteur ou semi-conducteur, réalisées sur une première face du support isolant **12.** Les bandes **14,** formées sensiblement parallèlement les unes par rapport aux autres et régulièrement espacées, s'étendent depuis une première zone **18** du support **12,** agencée sur le bord haut de celui-ci, vers une seconde zone **20** du support **12,** agencée sur le bord bas de celui-ci ;

■ un ensemble de bandes **22** en un matériau conducteur ou semi-conducteur (représentées en pointillés), réalisée sur une seconde face du support **12,** opposée à la première face. Les bandes **22,** également formées sensiblement parallèlement les unes par rapport aux autres et régulièrement espacées, s'étendent de la première zone **18** vers la seconde zone **20.** Les bandes **22** présentent en outre une direction différente de celle des bandes **14 ;**

■ un ensemble de contacts métalliques de connexion **24,** traversant le support isolant **12** et réalisés dans les zones **18** et **20.** Les contacts métalliques **24,** par exemple de section elliptique, sont régulièrement espacés et connectent électriquement entre elles des bandes **14, 22,** du premier et du second ensembles ; et

■ des contacts métalliques de collecte **26, 28** formés le long des bords gauche et droit du support **12,** le contact métallique de collecte **26** étant en contact uniquement avec des bandes **14** et le contact métallique de collecte **28** étant uniquement en contact avec des bandes **22.**

Les matériaux des bandes **14** et **22** sont différents de manière à présenter des coefficients Seebeck différents. Par exemple, les bandes **14** sont en un matériau semi-conducteur de type P, qui présente un coefficient Seebeck positif, et les bandes **22** sont réalisées en un matériau semi-conducteur de type N, qui présente un coefficient Seebeck négatif. Les matériaux semi-conducteurs des bandes 14, 22 sont par exemple choisis parmi des solutions solides de $Bi_2Te_3$, $Bi_2Se_3$ et de $Sb_2Te_3$, des matériaux à base de Si ou SiGe, des siliciures, des germaniures, des solutions solides à base de $Mg_2Si$, de $Mg_2Ge$ ou de $Mg_2Sn$, ou encore d'autres matériaux comme du PbTe ou du $PbSe_xTe_{1-x}$.

De préférence, les matériaux des bandes **14** et **22** sont sélectionnés pour présenter une différence de coefficients Seebeck en valeur absolue supérieure à 200 µV/K. De cette manière ces matériaux présentent un large coefficient ZT, et plus particulièrement un coefficient ZT supérieur ou égal à 1. Comme cela est connu, le coefficient ZT caractérise la qualité thermoélectrique d'un matériau et est classiquement désigné par l'expression « nombre de mérite » du matériau.

Les bandes **14, 22** sont par exemple obtenues par grattage, le support présentant alors des couches conductrices ou semi-conductrices revêtues d'un matériau isolant, par peignage, ou retrait de longue bande d'un film mince, comme cela est connu en soi de l'état de la technique.

On notera ainsi que la micro-structure **10** présente un ensemble de jonctions de matériaux ayant des coefficients Seebeck différents, par exemple des jonctions PN réalisées par les contacts métalliques **24,** lesdites jonctions étant agencées électriquement en série et thermiquement en parallèle entre les contacts métalliques de collecte **26, 28.**

Avantageusement, un contact métallique de connexion **24** connecte plusieurs bandes **14** du premier ensemble avec plusieurs bandes **22** du second ensemble. Il existe ainsi plusieurs chemins parallèles et indépendants pour le courant entre les contacts métalliques de collecte **26** et **28.**

Ainsi, en soumettant les bords haut et bas de la micro-structure **10** à des températures $T_h$ et $T_c$ différentes et en connectant les contacts de collecte **26, 28** à une charge **30** de manière à créer un circuit fermé, un courant est alors généré par effet Seebeck et s'écoule le long des chemins électriques formés de jonctions en série, comme par exemple le chemin illustré en gras sur la figure 1.

De préférence, les contacts métalliques de connexion **24** connectent plus de deux bandes adjacentes du même ensemble dans le plan du support **12,** par exemple trois ou quatre bandes adjacentes, de sorte que plusieurs agencements de jonctions en parallèle sont créés. Il existe donc, pour un chemin électrique entre les contacts de collecte **26, 28,** des branches de celui-ci constituées de plusieurs jonctions en parallèle entre les zones de connexion **18, 20.** Si une jonction ou un élément constitutif de celle-ci devient défectueux, il existe alors toujours une autre jonction valide pour le courant.

Dans un mode de réalisation privilégié, la densité des bandes par unité de surface est élevée de manière à obtenir une forte densité de jonctions par unité de volume, ce qui accroit la tension aux bornes des contacts de collecte **26, 28** et permet ainsi d'obtenir une micro-structure thermoélectrique utilisable dans des applications demandant de fortes puissances électriques.

Bien qu'il ait été décrit des bandes rectilignes, d'autres formes de bandes sont possibles. La figure 3 illustre par exemple une forme alternative du tracé des bandes **14.** Les bandes **14** peuvent ainsi prendre toute forme, comme une forme en « S » par exemple. Bien que les tracés rectilignes soient privilégiés pour des raisons de simplicité et de coût de fabrication, des formes non rectilignes peuvent être privilégiées, par exemple pour contourner une zone du support isolant **12** fonctionnalisée, comme une connexion, une zone de raccord ou autres.

De même, il a été décrit des bandes parallèles et régulièrement espacées. Comme cela est visible sur les figures 3 et 4, les bandes **14** (figure 3) et les bandes **22** (figure 4) peuvent présenter une dispersion dans leur espacement ou dans leur parallélisme jusqu'à se croiser.

De même, les différences de direction entre les bandes **14** du premier ensemble et les bandes **22** du second ensemble peuvent être très variables. En définissant le décalage d'une bande comme la distance selon l'axe des abscisses (axe « x ») séparant son extrémité dans la zone de connexion **18** de son extrémité dans la zone de connexion **20,** le décalage D1 des bandes **14** du premier ensemble est de même signe ou de signe différent du décalage D2 des bandes **22** du second ensemble, mais toujours différent. Par exemple, les décalages D1 et D2 sont choisis de façon à ce que sur la distance entre les zones de connexion **18, 20,** les bandes **14** du premier ensemble croisent les bandes **22** du second ensemble.

De même, il a été décrit des bandes. En variante, tout autre type d'éléments conducteurs ou semi-conducteurs longilignes convient. Par exemple, des fils, des nanofils, ou des monocristaux fibreux sont utilisés. Dans cette variante, les fils, nanofils ou microcristaux fibreux sont dispersés sur le support **12** puis alignés par un champ électrique, par exemple au moyen d'une technique d'électrophorèse. En variante, un film mince présentant une conductivité électrique anisotrope peut être utilisé sur chaque face d'un support isolant, chaque film ayant un axe de conduction maximale du courant selon une direction appropriée.

En variante, les éléments du premier ensemble sont constitués par un film mince et les éléments du second ensemble par des bandes. Toutefois, les bandes sont préférées car leurs directions d'anisotropie sont nettes. En revanche, un film peut être préféré pour sa simplicité de réalisation.

De même, il a été décrit des bandes dont les extrémités sont alignées de sorte que les zones de connexion **18** et **20** sont rectilignes. En variante, les extrémités des bandes peuvent suivre des tracés sinueux, par exemple pour éviter des zones spécifiques du support.

De même, il a été décrit une micro-structure biface dans laquelle les bandes **14** d'un premier type de matériau sont séparées des bandes **22** d'un second type de matériau par un support isolant **12**. L'utilisation d'un tel support permet notamment une isolation efficace et simple à réaliser des bandes **14** vis-à-vis des bandes **22**. En variante, les bandes **14** et **22** sont réalisées sur la même face du support isolant **22** en s'assurant que les bandes **14** soient électriquement isolées des bandes **22** lors de leur formation afin d'éviter tout phénomène de court circuit. Par exemple, les bandes sont des éléments de type nanofils constitués d'une âme en matériau conducteur ou semi-conducteur revêtu d'un matériau isolant. Les contacts **24** sont alors par exemple réalisés par perçage suivi d'une étape de métallisation (remplissage ou revêtement des trous par un métal) des trous ainsi créés. Le perçage met alors à nu l'âme des nanofils permettant donc la formation des jonctions.

D'une manière générale, un procédé privilégié de fabrication d'une micro-structure selon l'invention, consiste à :

■ former des bandes parallèles **14, 22** entre les zones de connexion **18** et **20** avec un espacement moyen respectif $d_1$, et $d_2$ (figure 3 et 4) tels que $d_1 \leq |D1\text{-}D2|$ et $d_2 \leq |D1\text{-}D2|$; et
■ former des contacts métalliques **24,** dont la largeur $P$ (figure 5) a une valeur moyenne $\overline{P}$ supérieure à max($d_1$, $d_2$) et une dispersion $\Delta P$ telle que :

$$\overline{P} - \Delta P > \max(d_1, d_2)$$

et dont l'espacement $E,$ c'est-à-dire la distance séparant deux bords adjacents de deux contacts **24,** est de préférence inférieure à min($d_1, d_2$) et avantageusement la plus petite possible sans que les contacts métalliques **24** ne se touchent. Selon l'invention, $\overline{P}$ > max($2d_1, 2d_2$) de manière à connecter ensemble plusieurs bandes d'un même ensemble.

En procédant ainsi, il est obtenu de manière certaine au moins un chemin de courant, et si la largeur $P$ des contacts **24** est augmentée et/ou l'espacement $d_1$ et $d_2$ des bandes **14, 22** diminué, il est obtenu plusieurs chemins électriques parallèles.

On notera tout particulièrement qu'il n'est pas nécessaire de positionner précisément les bandes **14, 22** les unes par rapport aux autres ou par rapport aux contacts métallique **24**. On notera ainsi que le procédé de fabrication est robuste en ce sens qu'il autorise des dispersions dans les dimensions ou les positionnements des différents éléments entrant dans la constitution des jonctions. Des matériels présentant des tolérances peu contraignantes peuvent ainsi être utilisés et/ou des cadences de fabrication élevées mises en oeuvre sans crainte des dispersions de fabrication induite.

Les contacts **24** sont par exemple obtenus par perçage du support isolant **12** suivi du remplissage ou du revêtement des trous ainsi créés par un métal. En variante, deux ouvertures longilignes sont créées. Des contacts métalliques individuels sont ensuite insérés dans celle-ci ou bien les ouvertures sont remplies de métal et le contact métallique longiligne ainsi obtenu est partitionné en éléments distincts, par exemple par gravure.

Par ailleurs, les contacts métalliques **26, 28** de collecte peuvent s'étendre sur toute la hauteur du support **12** ou seulement une partie de celle-ci, et/ou comprendre les coins du support 12. De préférence, les contacts de collecte **26, 28** s'étendent sur une grande partie de la distance entre les zones de connexion **18** et **20** de manière à être en contact avec plusieurs bandes.

De manière avantageuse, plusieurs micro-structures thermoélectriques selon l'invention peuvent être combinées pour obtenir une structure finale bidimensionnelle, en juxtaposant plusieurs structures du type de celle décrite en relation avec la figure 1, ou tridimensionnelle.

La figure 6 illustre par exemple un exemple de structure tridimensionnelle obtenue en combinant quatre micro-structures **10a, 10b, 10c, 10d,** selon l'invention, par exemple des micro-structures identiques à celles des figures 1 et 2.

L'obtention d'une structure tridimensionnelle est ainsi obtenue de façon simple en connectant électriquement d'une part les contacts électriques de collecte gauche **26a, 26b, 26c, 26d,** et d'autre part les contacts électriques de collecte droit **28a, 28b, 28c, 28d.** Les micro-structures **10a, 10b, 10c, 10d** sont ainsi mises en parallèle, ce qui renforce la robustesse de l'ensemble et augmente la puissance électrique disponible.

Un exemple numérique de réalisation d'une microstructure selon l'invention va être à présent décrit.

Il a été réalisé une micro-structure ayant :

■ un support isolant de 1,4m sur 1,4 mm et d'épaisseur égale à 0.01mm ;
■ sur une face du support, des fils semi-conducteurs de type n en $Bi_2Te_{2.7}Se_{0.3}$, de diamètre moyen égal à 0,002mm, et agencés avec une densité de 400 fils par mm ;
■ sur l'autre face du support, des fils semi-conducteurs de type p en $Bi_{0.5}Sb_{1.5}Te_3$ également de diamètre moyen égal à 0,002mm, et étant agencés avec une densité de 400 fils par mm ;
■ des contacts électriques de connexion d'une largeur moyenne de 0,016 mm avec un espacement moyen entre deux contacts égal à 0,004 mm. Les contacts sont réalisés en nickel plaqué sur du tellure de bismuth et présente ainsi une résistance surfacique de $10^{-9}$ $\Omega m^{-2}$. Ainsi, en moyenne 7 fils sont connectés à un contact.

Les fils de type p sont sensiblement rectilignes et présentent un angle moyen avec un axe vertical du support de 0,163 rad avec un écart type de 0,1 rad. De même, les fils de type n sont sensiblement rectilignes et présentent un angle moyen de -0,163 rad avec un écart type de 0,1 rad.

Le tableau suivant compare les propriétés électriques de l'exemple d'une telle micro-structure avec celles de la micro-structure, dite « Thermolife » présentée dans le document « Thermoelectric microdevice fabricated by a MEMS-like electrochemical process» de G. Jeffrey Snyder et al, Nature materiels, vol.2, août 2003, et dont les caractéristiques électriques sont accessibles sur le site http://www.poweredbythermolife.com/

| | Puissance maximale de fonctionnement ($\mu W/mm^2$) | Tension de fonctionnement ($V/mm^2$) | Courant de fonctionnement ($\mu A$) | Tension en circuit ouvert ($V/mm^2$) |
|---|---|---|---|---|
| Invention | 0,68 | 0,171 | 5,75 | 0,228 |
| Thermolife | 0,442 | 0,0442 | 10,00 | 0,0884 |

Grâce à l'invention, il est ainsi obtenu :

■ un procédé de fabrication ne nécessitant pas d'alignement précis, permettant ainsi d'obtenir un rendement de production élevée pour un coût moindre ;
■ un procédé de fabrication permettant de prendre en compte les spécificités du support et de son environnement par l'utilisation le cas échéant d'éléments conducteurs non rectilignes, permettant par exemple de contourner certaines zones du support ;
■ un procédé permettant d'obtenir une micro-structure biface ou simple face en fonction de l'application visée ;
■ une micro-structure thermoélectrique robuste par la mise en parallèle de plusieurs chemins de courant ;
■ une micro-structure thermoélectrique de forte tension par une densité élevée de jonction ; et
■ une micro-structure thermoélectrique apte à être combinée de manière simple avec d'autres micro-structures.

**Revendications**

**1.** Procédé de fabrication d'une micro-structure (10) thermoélectrique à effet Seebeck, comportant les étapes suivantes :

■ formation d'un support isolant (12) muni d'une première (18) et d'une seconde zone de connexion (20) ;
■ formation sur le support (12) d'un premier ensemble d'éléments conducteurs ou semi-conducteurs (14) s'étendant parallèlement entre eux, et selon une première direction, de la première zone de connexion (18) à la seconde zone de connexion (20), lesdits éléments (14) présentant un premier coefficient Seebeck ;
■ formation sur le support (12) d'un second ensemble d'éléments conducteurs ou semi-conducteurs (22), isolés électriquement des éléments (14) du premier ensemble, s'étendant parallèlement entre eux, et selon une seconde direction, différente de la première direction, de la première zone de connexion (18) à la seconde zone de connexion (20), les éléments (22) du second ensemble présentant un second coefficient Seebeck différent du premier coefficient Seebeck ; et
■ réalisation dans les première et seconde zones de connexion (18, 20) du support d'éléments de connexion électrique (24), dont les dimensions (P) sont sélectionnées de sorte que chacun desdits éléments de connexion (24) est apte à connecter électriquement au moins un élément (14) du premier ensemble à au moins un élément (22) du second ensemble, dans lequel
■ deux éléments conducteurs ou semi-conducteurs (14, 22) d'un même ensemble sont séparés, selon une direction prédéterminée, d'une distance ($d_1$, $d_2$) moyenne prédéterminée dans les zones de connexion (18, 20) ; et
■ la distance (E) selon la direction prédéterminée entre les bords de deux éléments de connexion (24) est inférienre au minimum des distances ($d_1$, $d_2$) moyennes séparant les éléments d'un même ensemble.
*caractérisé* **en ce que** :
■ la dimension (P) des éléments de connexion (24) selon la direction prédéterminée est en moyenne supérieure à deux fois le maximum des distances ($d_1$, $d_2$) moyennes séparant les éléments d'un même ensemble.

**2.** Procédé de fabrication d'une micro-structure (10) thermoélectrique à effet Seebeck selon la revendication 1, dans lequel, les premier et second ensembles d'éléments conducteurs ou semi-conducteurs sont formés respectivement sur des faces opposées du support isolant (12), et dans lequel la réalisation des éléments de connexion (24) comprend la formation de connexions électriques traversant le support entre lesdites faces, notamment la formation d'au moins un trou traversant le support suivi de la formation de contacts conducteurs au sein dudit trou.

**3.** Procédé de fabrication d'une micro-structure (10) thermoélectrique à effet Seebeck selon l'une quelconques des revendications précédentes, dans lequel les éléments conducteurs ou semi-conducteurs (14, 22) sont constitués par des bandes, des fils, des nanofils, et/ou des fibres microcristallines.

**4.** Procédé de fabrication d'une micro-structure (10) thermoélectrique à effet Seebeck selon la revendication 2, dans lequel les éléments conducteurs ou semi-conducteurs (14, 22) d'au moins un ensemble sont constitués par un film mince présentant une conductivité électrique anisotrope, apposé sur l'une des faces du support isolant, le film ayant un axe de conduction maximale du courant selon une direction différente de celles éléments de l'autre ensemble.

**5.** Micro-structure (10) pour générateur thermoélectrique à effet Seebeck comportant :

■ un support isolant (12) muni d'une première zone de connexion (18) et d'une seconde zone de connexion (20) ;
■ sur le support (12), un premier ensemble d'éléments conducteurs ou semi-conducteurs (14) s'étendant parallèlement entre eux, et selon une première direction, entre la première zone de connexion (18) et la seconde zone de connexion (20), lesdits éléments (14) présentant un premier coefficient Seebeck ;
■ sur le support (12), un second ensemble d'éléments conducteurs ou semi-conducteurs (22) isolés électriquement des éléments (14) du premier ensemble, s'étendant parallèlement entre eux, et selon une seconde direction différente de la première direction, de la première zone de connexion (18) à la seconde zone de connexion (20), les éléments (22) du second ensemble présentant un second coefficient Seebeck différent du premier coefficient Seebeck ; et
■ dans les première et seconde zones de connexion (18, 20), des éléments de connexion électrique (24) connectant électriquement au moins un élément (14) du premier ensemble à au moins un élément (22) du second ensemble, dans laquelle
■ deux éléments conducteurs ou semiconducteurs (14, 22) d'un même ensemble sont séparés, selon une direction prédéterminée, d'une distance ($d_1$, $d_2$) moyenne prédéterminée dans les zones de connexion (18, 20) ; et

■ la distance (E) selon la direction prédéterminée entre les bords de deux élément de connexion (24) est inférieure au minimum des distances ($d_1$, $d_2$) moyennes séparant les éléments d'un même ensemble.
*caractérisé* **en ce que** :

■ la dimension (P) des éléments de connexion (24) selon la direction prédéterminée est en moyenne supérieure à deux fois le maximum des distances ($d_1$, $d_2$) moyennes séparant les éléments d'un même ensemble.

**Claims**

1. A method for making a Seebeck effect thermoelectric microstructure (10), comprising the following steps:

   ■ forming an insulating substrate (12) provided with a first (18) and a second connection area (20);
   ■ forming on the substrate (12), a first assembly of conductor or semiconductor elements (14) extending in parallel with one another and in a first direction from the first connection area (18) to the second connection area (20), said elements (14) having a first Seebeck coefficient;
   ■ forming on the substrate (12), a second assembly of conductor or semiconductor elements (22) electrically insulated from the elements (14) of the first assembly and extending in parallel with one another and in a second direction other than the first direction, from the first connection area (18) to the second connection area (20), the elements (22) of the second assembly having a second Seebeck coefficient other than the first Seebeck coefficient; and
   ■ providing in the first and second connection areas (18, 20) of the substrate, electric connection elements (24), the dimensions (P) of which are selected so that each of said connection elements (24) is capable of electrically connecting at least one element (14) of the first assembly with at least one element (22) of the second assembly,
   method in which
   ■ two conductor or semiconductor elements (14, 22) of a single assembly are separated in a predetermined direction by a predetermined average distance ($d_1$, $d_2$) in the connection areas (18, 20);
   ■ the distance (E) in the predetermined direction between the edges of two connection elements (24) is less than the minimum of the average distances ($d_1$, $d_2$) between the elements of a single assembly ;

   **characterized in that** the average dimension (P) of the connection elements (24) in the predetermined direction is greater than twice the maximum of the average distances ($d_1$, $d_2$) between the elements of a single assembly.

2. The method for making a Seebeck effect thermoelectric microstructure (10) as claimed in claim 1, wherein the first and second assemblies of conductor or semiconductor elements are formed on opposite faces respectively of the insulating substrate (12), and wherein the provision of the connection elements (24) includes the formation of electrical connections passing through the substrate between said faces, and in particular the formation of at least one hole passing through the substrate followed by the formation of conductor contacts within said hole.

3. The method for making a Seebeck effect thermoelectric microstructure (10) as claimed in any one of the previous claims, wherein the conductor or semiconductor elements (14, 22) are constituted by bands, wires, nanowires, and/or single crystal fibres.

4. The method for making a Seebeck effect thermoelectric microstructure (10) as claimed in claim 2, wherein the conductor or semiconductor elements (14, 22) of at least one assembly are constituted by a thin film having anisotropic electric conductivity, affixed to one of the faces of the insulating substrate, the film having an axis of maximum current conduction in a direction other than that of the elements of the other assembly.

5. A microstructure (10) for a Seebeck effect thermoelectric generator comprising:

   ■ an insulating substrate (12) provided with a first connection area (18) and a second connection area (20);
   ■ on the substrate (12), a first assembly of conductor or semiconductor elements (14) extending in parallel with one another, and in a first direction, between the first connection area (18) and the second connection area (20), said elements (14) having a first Seebeck coefficient;
   ■ on the substrate (12), a second assembly of conductor or semiconductor elements (22) electrically insulated from the elements (14) of the first assembly, extending in parallel with one another, and in a second direction other than the first direction, from the first connection area (18) to the second connection area (20), the elements (22) of the second assembly having a second Seebeck coefficient other than the first Seebeck coefficient; and
■ in the first and second connection areas (18, 20), electric connection elements (24) electrically connecting at least one element (14) of the first assembly with at least one element (22) of the second assembly, microstructure in which :
■ two conductor or semiconductor elements (14, 22) of a single assembly are separated, in a predetermined direction, by a predetermined average distance ($d_1$, $d_2$) in the connection areas (18, 20);
■ the distance (E) in the predetermined direction between the edges of two connection elements (24) is less than the minimum of the average distances ($d_1$, $d_2$) between the elements of a single assembly.

**characterized in that** the average dimension (P) of the connection elements (24) in the predetermined direction is greater than twice the maximum of the average distances ($d_1$, $d_2$) between the elements of a single assembly.

**Patentansprüche**

1. Verfahren zur Herstellung einer thermoelektrischen Mikrostruktur (10) mit Seebeck-Effekt mit den folgenden Schritten:

   - Bildung eines isolierenden Trägers (12) mit einem ersten Verbindungsbereich (18) und einem zweiten Verbindungsbereich (20),
   - Bildung einer ersten Anordnung von leitenden bzw. halbleitenden Elementen (14) auf dem Träger (12), welche sich parallel zueinander und gemäß einer ersten Richtung von dem ersten Verbindungsbereich (18) zum zweiten Verbindungsbereich (20) erstrecken, wobei die Elemente (14) einen ersten Seebeck-Koeffizienten aufweisen,
   - Bildung einer zweiten Anordnung von leitenden bzw. halbleitenden Elementen (22) auf dem Träger (12), welche gegenüber den Elementen (14) der ersten Anordnung elektrisch isoliert sind, sich parallel zueinander und gemäß einer zweiten, von der ersten unterschiedlichen Richtung von dem ersten Verbindungsbereich (18) zum zweiten Verbindungsbereich (20) erstrecken, wobei die Elemente (22) der zweiten Anordnung einen zweiten, von dem ersten unterschiedlichen Seebeck-Koeffizienten aufweisen, und
   - Ausbildung in dem ersten und in dem zweiten Verbindungsbereich (18, 20) des Trägers von Elementen (24) für eine elektrische Verbindung, deren Abmessungen (P) derart ausgewählt sind, dass das jeweilige Verbindungselement (24) geeignet ist, mindestens ein Element (14) der ersten Anordnung mit mindestens einem Element (22) der zweiten Anordnung elektrisch zu verbinden, bei dem
   - zwei leitende bzw. halbleitende Elemente (14, 22) ein und derselben Anordnung gemäß einer vorbestimmten Richtung um einen mittleren, vorbestimmten Abstand (d1, d2) in den Verbindungsbereichen (18, 20) beabstandet sind, und
   - der Abstand (E) gemäß der vorbestimmten Richtung zwischen den Kanten zweier Verbindungselemente (24) geringer ist als das Minimum der mittleren Abstände ($d_1$, $d_2$) zwischen den Elementen ein und derselben Anordnung,

   **dadurch gekennzeichnet, dass**
   das Maß (P) der Verbindungselemente (24) gemäß der vorbestimmten Richtung im Durchschnitt größer ist als zwei Mal das Maximum der mittleren Abstände ($d_1$, $d_2$) zwischen den Elementen ein und derselben Anordnung.

2. Verfahren zur Herstellung einer thermoelektrischen Mikrostruktur (10) mit Seebeck-Effekt nach Anspruch 1, bei dem die erste und die zweite Anordnung von leitenden bzw. halbleitenden Elementen jeweils auf entgegengesetzten Seiten des isolierenden Trägers (12) gebildet sind und bei dem die Ausbildung der Verbindungselemente (24) die Bildung von elektrischen Verbindungen durch den Träger hindurch zwischen den genannten Seiten, insbesondere die Bildung mindestens eines Lochs durch den Träger hindurch mit anschließender Bildung von leitenden Kontakten innerhalb des Lochs umfasst.

3. Verfahren zur Herstellung einer thermoelektrischen Mikrostruktur (10) mit Seebeck-Effekt nach einem beliebigen der vorhergehenden Ansprüche, bei dem die leitenden bzw. halbleitenden Elemente (14, 22) durch Streifen, Fäden, Nanofäden und/oder mikrokristalline Fasern gebildet sind.

4. Verfahren zur Herstellung einer thermoelektrischen Mikrostruktur (10) mit Seebeck-Effekt nach Anspruch 2, bei dem die leitenden bzw. halbleitenden Elemente (14, 22) mindestens einer Anordnung durch einen dünnen Film gebildet sind, der eine anisotrope elektrische Leitfähigkeit aufweist und auf einer der Seiten des isolierenden Trägers angebracht ist, wobei der Film eine Achse der maximalen Stromleitfähigkeit gemäß einer Richtung aufweist, die von denjenigen der Elemente der anderen Anordnung unterschiedlich ist.

5. Mikrostruktur (10) für einen thermoelektrischen Generator mit Seebeck-Effekt, umfassend:

- einen isolierenden Träger (12) mit einem ersten Verbindungsbereich (18) und einem zweiten Verbindungsbereich (20),
- eine erste Anordnung von leitenden bzw. halbleitenden Elementen (14) auf dem Träger (12), welche sich parallel zueinander und gemäß einer ersten Richtung zwischen dem ersten Verbindungsbereich (18) und dem zweiten Verbindungsbereich (20) erstrecken, wobei die Elemente (14) einen ersten Seebeck-Koeffizienten aufweisen,
- eine zweite Anordnung von leitenden bzw. halbleitenden Elementen (22) auf dem Träger (12), welche gegenüber den Elementen (14) der ersten Anordnung elektrisch isoliert sind, sich parallel zueinander und gemäß einer zweiten, von der ersten unterschiedlichen Richtung von dem ersten Verbindungsbereich (18) zum zweiten Verbindungsbereich (20) erstrecken, wobei die Elemente (22) der zweiten Anordnung einen zweiten, von dem ersten unterschiedlichen Seebeck-Koeffizienten aufweisen, und
- in dem ersten und in dem zweiten Verbindungsbereich (18, 20) Elemente (24) für eine elektrische Verbindung, die mindestens ein Element (14) der ersten Anordnung mit mindestens einem Element (22) der zweiten Anordnung elektrisch verbinden, bei der
- zwei leitende bzw. halbleitende Elemente (14, 22) ein und derselben Anordnung gemäß einer vorbestimmten Richtung um einen mittleren, vorbestimmten Abstand (d1, d2) in den Verbindungsbereichen (18, 20) beabstandet sind, und
- der Abstand (E) gemäß der vorbestimmten Richtung zwischen den Kanten zweier Verbindungselemente (24) geringer ist als das Minimum der mittleren Abstände ($d_1$, $d_2$) zwischen den Elementen ein und derselben Anordnung,

**dadurch gekennzeichnet, dass**
- das Maß (P) der Verbindungselemente (24) gemäß der vorbestimmten Richtung im Durchschnitt größer ist als zwei Mal das Maximum der mittleren Abstände ($d_1$, $d_2$) zwischen den Elementen ein und derselben Anordnung.

**Fig. 1**

**Fig. 2**

Fig. 3

Fig. 4

Fig. 5

**Fig. 6**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6872879 B

- US 20050178424 A

**Littérature non-brevet citée dans la description**

- **G. JEFFREY SNYDER et al.** Thermoelectric micro-device fabricated by a MEMS-like electrochemical process. *Nature materiels,* Août 2003, vol. 2, www.nature.com/naturematerial

- **G. JEFFREY SNYDER et al.** Thermoelectric micro-device fabricated by a MEMS-like electrochemical process. *Nature materiels,* Août 2003, vol. 2, http://www.poweredbythermolife.com